# EUROPÄISCHE PATENTSCHRIFT

(11) **EP 2 304 855 B1**
(45) Veröffentlichungstag und Bekanntmachung des Hinweises auf die Patenterteilung: **27.05.2015**
(21) Anmeldenummer: 09779997.7
(22) Anmeldetag: 29.06.2009
(51) Int. Cl.: H01S 5/062, H01S 5/0687, F02P 23/04, H01S 3/102, H01S 3/131, H01S 5/06

(54) **VORRICHTUNG UND VERFAHREN ZUM BETREIBEN EINES HALBLEITERLASERS**
DEVICE AND METHOD FOR OPERATING A SEMICONDUCTOR LASER
DISPOSITIF ET PROCÉDÉ DE FONCTIONNEMENT D'UN LASER SEMICONDUCTEUR

(30) Priorität: 30.07.2008 DE 102008040864
(43) Veröffentlichungstag der Anmeldung: 06.04.2011
(73) Patentinhaber: Robert Bosch GmbH, 70442 Stuttgart (DE)
(72) Erfinder: HERDEN, Werner, 70839 Gerlingen (DE)
(86) Internationale Anmeldenummer: PCT/EP2009/058093
(87) Internationale Veröffentlichungsnummer: WO 2010/012556

(56) Entgegenhaltungen:
- WO-A-2008/022914
- DE-A1- 3 005 645
- US-A- 5 400 351
- US-A1- 2002 009 110
- US-A1- 2006 018 350

## Beschreibung

### Stand der Technik

Die Erfindung betrifft ein Verfahren zum Betreiben eines Halbleiterlasers, bei dem der Halbleiterlaser in einer ersten Betriebsphase so mit einem ersten Ansteuerstrom angesteuert wird, dass er ausgehend von einer Ausgangstemperatur eine vorgebbare Solltemperatur annimmt.

Die Erfindung betrifft ferner eine Steuereinrichtung zur Ansteuerung eines Halbleiterlasers mit einem Ansteuerstrom und ein Halbleiterlasermodul.

Ein Verfahren der eingangs genannten Art ist bereits aus der DE 10 2006 039 398 A1 bekannt. Das bekannte Verfahren hat zum Ziel, den Halbleiterlaser zunächst auf die gewünschte Solltemperatur zu temperieren, wozu bevorzugt ein Ansteuerstrom verwendet wird, der im Bereich des Schwellstroms des Diodenlasers liegt. Für eine effektive Erzeugung von Pumplicht einer gewünschten Wellenlänge sieht das bekannte System ferner vor, den Diodenlaser in einer nachfolgenden zweiten Betriebsart mit einem Ansteuerstrom zu beaufschlagen, der um ein Vielfaches größer ist als der Schwellstrom des Diodenlasers. Dadurch wird der Diodenlaser mit einem gegenüber der ersten Betriebsart gesteigerten Wirkungsgrad betrieben. Nachteilig an dieser Verfahrensweise ist jedoch die weitere, verstärkte Aufheizung des Diodenlasers durch die zweite Betriebsart beziehungsweise den hierbei verwendeten großen Ansteuerstrom. Diese weitere Aufheizung bewirkt, dass sich die Wellenlänge der erzeugten Laserstrahlung bzw. des Pumplichts entsprechend ändert, so dass u.U. kein effizientes optisches Pumpen einer nachgeordneten Lasereinrichtung möglich ist, was insbesondere für solche Lasereinrichtungen gilt, deren Absorptionsspektren sehr schmale Maxima von z.B. nur wenigen Nanometern aufweisen.

Ein Verfahren der Eingangs genannten Art ist ebenfalls aus der US 2002/0009110 A1 bekannt.

### Offenbarung der Erfindung

Demgemäß ist es Aufgabe der vorliegenden Erfindung, ein Betriebsverfahren, eine Steuereinrichtung und ein Halbleiterlasermodul der eingangs genannten Art dahingehend zu verbessern, dass eine präzisere Temperierung des Halbleiterlasers, insbesondere auf eine konstante Solltemperatur, und damit auch die Erzeugung von Laserlicht einer konstanten Wellenlänge, möglich ist.

Diese Aufgabe wird bei dem Verfahren der eingangs genannten Art erfindungsgemäß durch ein Verfahren gemäß Anspruch 1 und einer Vorrichtung gemäß Anspruch 8 gelöst.

Das heißt, im Gegensatz zu dem herkömmlichen Betriebsverfahren wird erfindungsgemäß auch in weiteren als der ersten Betriebsphase der Ansteuerstrom für den Halbleiterlaser vorteilhaft so gewählt, dass sich auch in den weiteren Betriebsphasen die gewünschte Solltemperatur einstellt beziehungsweise beibehalten wird.

Besonders bevorzugt wird der Halbleiterlaser einer Erfindungsvariante zufolge auf eine Solltemperatur erwärmt, die größer ist als die Ausgangstemperatur.

Um eine besonders schnelle Erwärmung des Halbleiterlasers während der ersten Betriebsphase zu ermöglichen, kann erfindungsgemäß vorgesehen sein, dass der erste Ansteuerstrom zumindest zeitweise einem für den Betrieb des Halbleiterlasers maximal zulässigen Ansteuerstrom entspricht.

Erfindungsgemäß weist der erste Ansteuerstrom einen konstanten Zeitverlauf auf, beispielsweise kann der erste Ansteuerstrom so gewählt werden, dass er dem maximal zulässigen Ansteuerstrom des Halbleiterlasers entspricht, und erfindungsgemäß weist der zweite Ansteuerstrom einen nichtkonstanten Zeitverlauf auf, wobei sich der zweite Ansteuerstrom sich kontinuierlich verringert bzw. verringert wird, insbesondere bis auf einen zum Aufrechterhalten der Solltemperatur erforderlichen Minimalwert. Der genaue zeitliche Verlauf des zweiten Ansteuerstroms wird vorteilhaft bevorzugt experimentell oder modellbasiert ermittelt und hängt insbesondere von der Konfiguration des Halbleiterlasers ab, speziell von solchen Komponenten, die den Wärmetransport weg von dem Halbleiterlaser realisieren.

Sofern beispielsweise der Halbleiterlaser in thermischem Kontakt steht mit einem Kühlkörper oder einer Kühlfläche von besonders großer Wärmekapazität, kann die erste Betriebsphase zum Aufheizen des Halbleiterlasers länger durchgeführt werden, als bei einer Konfiguration des Halbleiterlasers, bei der nur Komponenten mit verhältnismäßig geringer Wärmekapazität in thermischem Kontakt mit dem Halbleiterlaser stehen.

Eine maximale Effizienz bei dem erfindungsgemäßen Betrieb des Halbleiterlasers ergibt sich einer weiteren vorteilhaften Erfindungsvariante zufolge dann, wenn die Solltemperatur so gewählt wird, dass sie einer maximal zulässigen Junctiontemperatur des Halbleiterlasers entspricht. Besonders vorteilhaft wird der Halbleiterlaser konstruktiv so ausgelegt, dass er bei seiner maximal zulässigen Junctiontemperatur Laserstrahlung der gewünschten Wellenlänge emittiert.

Die vorstehend beschriebenen Varianten des erfindungsgemäßen Betriebsverfahrens ermöglichen vorteilhaft einen rein gesteuerten und damit wenig aufwendigen Betrieb eines Halbleiterlasers bei gleichzeitiger Stabilisierung des Halbleiterlasers auf der gewünschten Solltemperatur. Vorteilhaft können experimentell oder modellbasiert ermittelte Stromverläufe für den ersten und zweiten Ansteuerstrom, die die gewünschte Temperierung ergeben, in einer entsprechenden Steuereinrichtung nichtflüchtig gespeichert und für den gesteuerten Normalbetrieb des Halbleiterlasers verwendet werden.

Ein noch präziseres Einhalten der gewünschten Solltemperatur für den Halbleiterlaser kann einer weiteren vorteilhaften Ausführungsform des erfindungsgemäßen Betriebsverfahrens zufolge dadurch erreicht werden, dass eine von einer Wellenlänge der von dem Halbleiterlaser erzeugten Laserstrahlung abhängige Größe messtechnisch ermittelt wird. Die Auswertung dieser Größe erlaubt aufgrund der Temperaturabhängigkeit der Wellenlänge der von dem Halbleiterlaser abgestrahlten Laserstrahlung Rückschlüsse auf eine tatsächliche Temperatur des Halbleiterlasers und somit die Realisierung eines Regelkreises, bei dem die Ansteuerströme der erfindungsgemäßen ersten und zweiten Betriebsphase in Abhängigkeit der messtechnisch ermittelten Größe festgelegt werden.

Einer weiteren vorteilhaften Erfindungsvariante zufolge kann von dem Halbleiterlaser erzeugte Strahlung, insbesondere Streulicht, mittels eines optischen Filters gefiltert werden, und die gefilterte Strahlung kann mittels eines Photodetektors detektiert werden, um Informationen über eine tatsächliche Temperatur des Halbleiterlasers zu erhalten. Das Ausgangssignal des beispielsweise als Photodiode ausgebildeten Photodetektors gibt hierbei an, wie gut die Wellenlänge der von dem Halbleiterlaser erzeugten Laserstrahlung übereinstimmt mit einer Wellenlänge maximaler Transmission des optischen Filters.

Das optische Filter wird beispielsweise so ausgewählt, dass seine Wellenlänge maximaler Transmission der gewünschten Wellenlänge für die erzeugte Laserstrahlung entspricht. In diesem Fall kann der Ansteuerstrom für den Halbleiterlaser während der erfindungsgemäßen Betriebsphasen mit dem Ziel der Maximierung des Ausgangssignals der Photodiode gewählt werden. Ganz besonders vorteilhaft kann der Ansteuerstrom für die erfindungsgemäßen Betriebsphasen demnach direkt in Abhängigkeit des Ausgangssignals des Photodetektors eingestellt werden.

Aufgrund der hohen Temperatur- und damit auch Wellenlängenstabilität des erfindungsgemäß betriebenen Halbleiterlasers eignet sich der Halbleiterlaser besonders gut zum optischen Pumpen einer Lasereinrichtung, beispielsweise eines laseraktiven Festkörpers mit einer passiven Güteschaltung. Die Solltemperatur für die erfindungsgemäße Temperierung des Halbleiterlasers wird hierbei vorteilhaft so gewählt, dass in Abhängigkeit des verwendeten Lasermaterials der zu pumpenden Anordnung und des Temperaturkoeffizienten des Halbleiterlasers ein besonders effizientes optisches Pumpen möglich ist.

Die Gesamtdauer eines Pumpvorgangs, bestehend aus einer ersten und einer zweiten Betriebsphase, liegt bevorzugt zwischen 50 µs und 5 ms, besonders bevorzugt zwischen 200 µs und 1 ms.

Als eine weitere Lösung der Aufgabe der vorliegenden Erfindung ist eine Vorrichtung gemäß Anspruch 8 angegeben.

Vorteilhafte Ausgestaltungen der Erfindung sind Gegenstand der Unteransprüche.

Von besonderer Bedeutung ist die Realisierung des erfindungsgemäßen Betriebsverfahrens in Form eines Computerprogramms, das auf einem elektronischen Speichermedium abspeicherbar ist und beispielsweise einer das Betriebsverfahren ausführenden Steuereinrichtung beziehungsweise einer Recheneinheit einer derartigen Steuereinrichtung zugeordnet sein kann.

Weitere Merkmale, Anwendungsmöglichkeiten und Vorteile der Erfindung ergeben sich aus der nachfolgenden Beschreibung von Ausführungsbeispielen der Erfindung, die in den Figuren der Zeichnung dargestellt sind.

In der Zeichnung zeigt:
- Figur 1: eine schematische Darstellung einer Brennkraftmaschine mit einem laserbasierten Zündsystem, bei dem ein erfindungsgemäß betriebener Halbleiterlaser zur Erzeugung von Pumplicht verwendet wird,
- Figur 2: eine Lasereinrichtung mit passiver Güteschaltung,
- Figur 3: einen zeitlichen Verlauf eines Ansteuerstroms für den Halbleiterlaser gemäß einer Ausführungsform des erfindungsgemäßen Betriebsverfahrens,
- Figur 4A: eine Draufsicht auf eine erste Ausführungsform eines erfindungsgemäßen Halbleiterlasermoduls,
- Figur 4B: eine Seitenansicht des erfindungsgemäßen Halbleitermoduls aus Figur 4A, und
- Figur 5: eine Draufsicht auf eine zweite Ausführungsform eines erfindungsgemäßen Halbleiterlasermoduls.

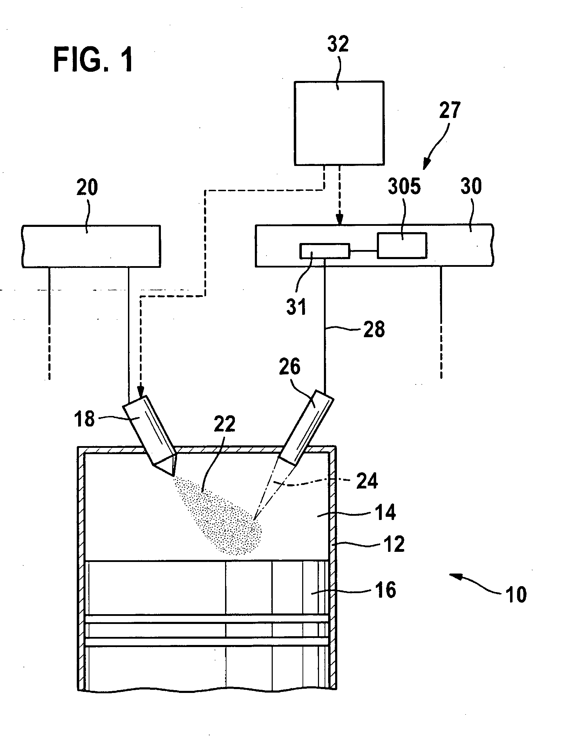

Eine Brennkraftmaschine trägt in Figur 1 insgesamt das Bezugszeichen 10. Sie dient zum Antrieb eines nicht dargestellten Kraftfahrzeugs. Die Brennkraftmaschine 10 umfasst mehrere Zylinder, von denen in Figur 1 nur einer mit dem Bezugszeichen 12 bezeichnet ist. Ein Brennraum 14 des Zylinders 12 wird von einem Kolben 16 begrenzt. Kraftstoff gelangt in den Brennraum 14 direkt durch einen Injektor 18, der an einen auch als Rail beziehungsweise Common-Rail bezeichneten Kraftstoffdruckspeicher 20 angeschlossen ist.

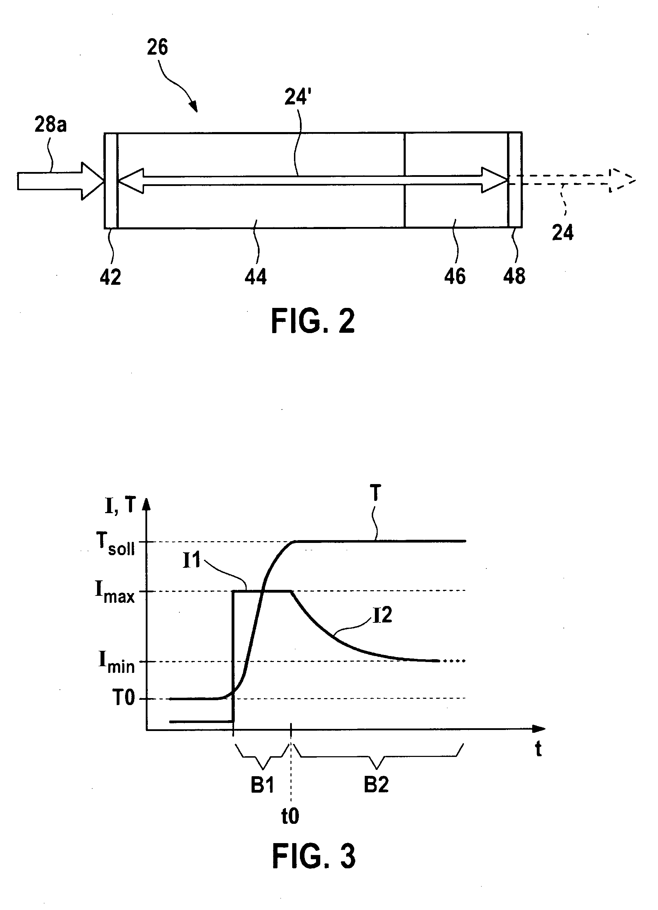

In den Brennraum 14 eingespritzter Kraftstoff 22 wird mittels eines Laserimpulses 24 entzündet, der von einer eine Lasereinrichtung 26 umfassenden Zündeinrichtung 27 in den Brennraum 14 abgestrahlt wird. Hierzu wird die Lasereinrichtung 26 über eine Lichtleitereinrichtung 28 mit einem Pumplicht gespeist, welches von einer Pumplichtquelle 30 bereitgestellt wird. Die Pumplichtquelle 30 weist zur Erzeugung des Pumplichts einen erfindungsgemäß betriebenen Halbleiterlaser 31 auf, dessen Funktion später unter Bezugnahme auf die Figuren 3 bis 5 näher beschrieben wird. Eine Ansteuerung der Pumplichtquelle 30 erfolgt durch ein Steuergerät 32, das auch den Injektor 18 ansteuert.

In die Pumplichtquelle 30 ist ferner eine spezielle Steuereinrichtung 305 integriert, die den Halbleiterlaser 31 erfindungsgemäß in Abhängigkeit der übergeordneten Steuerung durch das Steuergerät 32 ansteuert. Die Steuereinrichtung 305 kontrolliert insbesondere die Erzeugung von Ansteuerströmen für den Halbleiterlaser 31, um die Lasereinrichtung 26 in geeigneter Weise mit Pumplicht versorgen zu können.

Figur 2 zeigt schematisch eine Detailansicht der Lasereinrichtung 26 aus Figur 1.

Wie aus Figur 2 ersichtlich, weist die Lasereinrichtung 26 einen laseraktiven Festkörper 44 auf, dem eine auch als Q-switch bezeichnete passive Güteschaltung 46 optisch nachgeordnet ist. Der laseraktive Festkörper 44 bildet hierbei zusammen mit der passiven Güteschaltung 46 sowie dem in Figur 2 links hiervon angeordneten Einkoppelspiegel 42 und dem Auskoppelspiegel 48 einen Laser-Oszillator aus, dessen Schwingverhalten in bekannter Weise von der passiven Güteschaltung 46 abhängt.

Bei der in Figur 2 abgebildeten Konfiguration wird die Lasereinrichtung 26 beziehungsweise der laseraktive Festkörper 44 durch den Einkoppelspiegel 42 hindurch mit Pumplicht 28a beaufschlagt, das Elektronen in dem laseraktiven Festkörper 44 anregt und dementsprechend zu einer Besetzungsinversion führt. Das Pumplicht 28a wird der Lasereinrichtung 26 - wie vorstehend bereits unter Bezugnahme auf Figur 1 beschrieben - über die Lichtleitereinrichtung 28 zugeführt, die den Halbleiterlaser 31 optisch mit der Lasereinrichtung 26 verbindet.

Während die passive Güteschaltung 46 ihren Ruhezustand aufweist, in dem sie einen verhältnismäßig geringen Transmissionskoeffizienten besitzt, wird ein Laser-Betrieb in dem laseraktiven Festkörper 44 beziehungsweise in dem durch den Einkoppelspiegel 42 und den Auskoppelspiegel 48 begrenzten Festkörper 44, 46 vermieden. Mit steigender Pumpdauer, d.h., während einer Beaufschlagung mit dem Pumplicht 28a, steigt jedoch auch die Strahlungsintensität in dem Laser-Oszillator 42, 44, 46, 48 an, so dass die passive Güteschaltung 46 schließlich ausbleicht. Das heißt, ihr Transmissionskoeffizient steigt, und ein Laser-Betrieb in dem Laser-Oszillator 42, 44, 46, 48 beginnt. Dieser Zustand ist durch den Doppelpfeil 24' symbolisiert.

Auf die vorstehend beschriebene Weise entsteht ein auch als Riesenimpuls bezeichneter Laserimpuls 24, der eine verhältnismäßig hohe Spitzenleistung aufweist. Der Laserimpuls 24 wird, gegebenenfalls unter Verwendung einer weiteren Lichtleitereinrichtung (nicht gezeigt), oder auch direkt durch ein ebenfalls nicht abgebildetes Brennraumfenster der Lasereinrichtung 26 in den Brennraum 14 (Figur 1) der Brennkraftmaschine 10 eingekoppelt, so dass darin vorhandener Kraftstoff 22 beziehungsweise ein Luft-/Kraftstoffgemisch entzündet wird.

Um ein besonders effizientes optisches Pumpen der Lasereinrichtung 26 zu ermöglichen, sieht das erfindungsgemäße Betriebsverfahren eine spezielle Ansteuerung des Halbleiterlasers 31 (Figur 1) durch die Steuereinrichtung 305 vor, die nachstehend unter Bezugnahme auf Figur 3 beschrieben ist. Figur 3 gibt den zeitlichen Verlauf eines erfindungsgemäß vorgesehenen Ansteuerstroms für den Halbleiterlaser 31 und eine sich hierbei einstellende Temperatur des Halbleiterlasers 31 wieder.

Wie aus Figur 3-ersichtlich wird der Halbleiterlaser 31 in einer ersten Betriebsphase B1 zunächst so mit einem ersten Ansteuerstrom I1 angesteuert, dass er ausgehend von einer Ausgangstemperatur T0 eine vorgebbare Solltemperatur Tsoll annimmt.

Hierzu wird in der ersten Betriebsphase B1 ein besonders einfach zu erzeugender konstanter erster Ansteuerstrom I1 eingestellt, der bevorzugt einem für den Betrieb des Halbleiterlasers 31 maximal zulässigen Ansteuerstrom Imax entspricht, um den Halbleiterlaser 31 möglichst schnell auf die Solltemperatur Tsoll zu erwärmen. Dadurch wird vorteilhaft eine besonders kurze Dauer der ersten Betriebsphase B1 erzielt, während der der Halbleiterlaser 31 aufgrund der Temperaturänderung auch eine entsprechende Änderung seiner Ausgangswellenlänge erfährt.

Anschließend, d.h. ab dem Zeitpunkt t0, zu dem der Halbleiterlaser 31 die Solltemperatur Tsoll erreicht hat, wird der Halbleiterlaser 31 in einer zweiten Betriebsphase B2 so mit einem zweiten Ansteuerstrom I2 angesteuert, dass der Halbleiterlaser 31 die Solltemperatur Tsoll während der zweiten Betriebsphase im wesentlichen beibehält. Dadurch ist erfindungsgemäß vorteilhaft gewährleistet, dass der Halbleiterlaser 31 zumindest ab dem Zeitpunkt t0 Laserstrahlung mit konstanter Wellenlänge emittiert, die besonders gut als Pumplicht 28a (Figur 2) zum optischen Pumpen der Lasereinrichtung 26 geeignet ist.

Wie aus Figur 3 ersichtlich ist, weist der zweite Ansteuerstrom I2 i.d.R. einen nichtkonstanten zeitlichen Verlauf auf und verringert sich ab dem Zeitpunkt t0 zunächst kontinuierlich, was vorteilhaft bewirkt, dass eine weitere Erwärmung über die Solltemperatur Tsoll hinaus vermieden wird.

Der genaue zeitliche Verlauf insbesondere des zweiten Ansteuerstroms 12 wird vorteilhaft bevorzugt experimentell oder modellbasiert ermittelt und hängt insbesondere von der Konfiguration des Halbleiterlasers 31 ab, speziell von solchen Komponenten, die den Wärmetransport weg von dem Halbleiterlaser 31 realisieren.

Erfindungsgemäß ist der zeitliche Verlauf des zweiten Ansteuerstroms I2 für die zweite Betriebsphase B2 so gewählt, dass die an dem Halbleiterlaser 31 auftretenden Wärmeverluste (durch Kühlkörper abgeführte Wärmemenge und dergleichen) durch den Betrieb mit dem zweiten Ansteuerstrom I2 ausgeglichen werden, um eine Temperierung des Halbleiterlasers 31 auf die Solltemperatur Tsoll zu gewährleisten.

Während der weiteren Ansteuerung des Halbleiterlasers 31 in der zweiten Betriebsphase B2 wird der zweite Ansteuerstrom I2 wie aus Figur 3 ersichtlich kontinuierlich verringert, bis er einen zum Aufrechterhalten der Solltemperatur Tsoll erforderlichen Minimalwert Imin erreicht. Dieser Minimalwert Imin wird solange beibehalten, bis die gewünschte Pumpdauer zum optischen Pumpen der Lasereinrichtung 26 (Figur 2) erreicht ist.

Es ist offensichtlich, dass bei einem geplanten Ende der Pumpdauer noch vor dem Erreichen des thermischen Gleichgewichts bzw. des damit korrespondierenden Minimalwerts Imin für den zweiten Ansteuerstrom I2 die Bestromung des Halbleiterlasers 31 entsprechend früher beendet werden kann.

Eine maximale Effizienz bei dem Betrieb des Halbleiterlasers 31 als Pumplichtquelle für die Lasereinrichtung 26 ist vorteilhaft dann gegeben, wenn die einzustellende Solltemperatur Tsoll so gewählt wird, dass sie einer maximal zulässigen Junctiontemperatur des Halbleiterlasers 31 entspricht, und wenn der Halbleiterlaser 31 so ausgelegt ist, dass er bei der maximal zulässigen Junctiontemperatur die gewünschte Wellenlänge für das Pumplicht 28a emittiert. D.h. der erfindungsgemäße Halbleiterlaser 31 ist so auszulegen, dass er hinsichtlich seiner Ausgangswellenlänge bei der maximal zulässigen Junctiontemperatur im Absorptionsmaximum des zu pumpenden laseraktiven Festkörpers 44 liegt.

Die vorstehend beschriebene Variante des erfindungsgemäßen Betriebsverfahrens ermöglicht vorteilhaft einen rein gesteuerten und damit wenig aufwendigen Betrieb des Halbleiterlasers 31 in der Pumplichtquelle 30 (Figur 1). Vorteilhaft können die experimentell oder modellbasiert ermittelten Stromverläufe für den ersten und zweiten Ansteuerstrom I1, I2, die die gewünschte Temperierung und damit Ausgangswellenlänge des Halbleiterlasers 31 ergeben, in der Steuereinrichtung 305 nichtflüchtig gespeichert und für den gesteuerten Normalbetrieb des Halbleiterlasers 31 verwendet werden. Dies gilt ebenfalls für den Minimalwert Imin (Figur 3) des zweiten Ansteuerstroms I2.

Eine weitere Steigerung der Präzision bei der Einhaltung der gewünschten Solltemperatur Tsoll bzw. Ausgangswellenlänge des Halbleiterlasers 31 kann einer weiteren vorteilhaften Ausführungsform des erfindungsgemäßen Betriebsverfahrens zufolge dadurch erreicht werden, dass eine von einer Wellenlänge der von dem Halbleiterlaser 31 erzeugten Laserstrahlung abhängige Größe messtechnisch ermittelt wird. Die Auswertung dieser Größe erlaubt aufgrund der Temperaturabhängigkeit der Wellenlänge der von dem Halbleiterlaser 31 abgestrahlten Laserstrahlung Rückschlüsse auf eine tatsächliche Temperatur des Halbleiterlasers 31 und somit die Realisierung eines Regelkreises, bei dem die Ansteuerströme I1, I2 der erfindungsgemäßen ersten und zweiten Betriebsphase B1, B2 in Abhängigkeit der messtechnisch ermittelten Größe festgelegt werden.

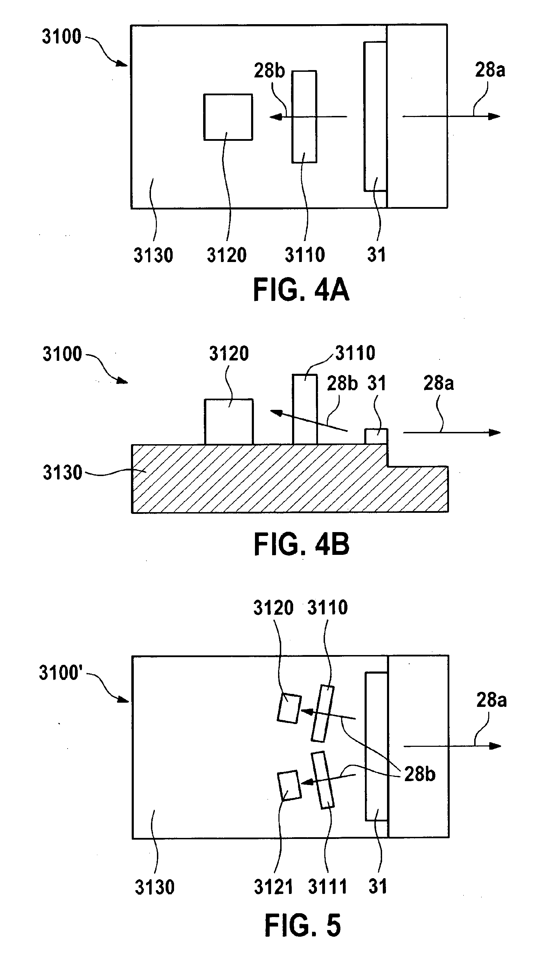

Für die Realisierung der vorstehend beschriebenen geregelt betriebenen Erfindungsvariante eignet sich bevorzugt die in Figur 4A, 4B angegebene Konfiguration eines einen Halbleiterlaser 31 aufweisenden Halbleiterlasermoduls 3100, das ebenfalls in die Pumplichtquelle 30 (Figur 1) integrierbar ist. Figur 4A zeigt eine vereinfachte Draufsicht auf das Halbleiterlasermodul 3100, während Figur 4B eine Seitenansicht 4b in teilweisem Querschnitt wiedergibt.

Neben dem Halbleiterlaser 31 weist das erfindungsgemäße Halbleiterlasermodul 3100 ein optisches Filter 3110 und einen dem optischen Filter 3110 zugeordneten Detektor 3120 auf. Der Detektor 3120 dient zur Detektion und/oder Umwandlung von mittels des optischen Filters 3110 gefilterter Strahlung des Halbleiterlasers 31. Das optische Filter 3110 und der Detektor 3120 sind zusammen mit dem Halbleiterlaser 31 auf einem gemeinsamen Substrat 3130 angeordnet, das u.a. auch die Funktion einer Kühleinrichtung aufweisen kann und hierzu z.B. aus Kupfer gebildet ist.

Erfindungsgemäß sind die Komponenten 3110, 3120 so in dem Halbleiterlasermodul 3100 relativ zu dem Halbleiterlaser 31 angeordnet, dass sie von in dem Halbleiterlasermodul 3100 gestreuter Strahlung 28b des Halbleiterlasers 31 bestrahlbar sind. Die Streustrahlung 28b ist bezüglich ihrer Intensität zur erfindungsgemäßen Wellenlängen- bzw. Temperaturermittlung völlig ausreichend, so dass vorteilhaft keine Komponenten 3110, 3120 in einer Hauptstrahlrichtung (in Figur 4A rechts von dem Halbleiterlaser 31) der als Pumplicht 28a verwendbaren Laserstrahlung angeordnet sein müssen.

Das optische Filter 3110 wird beispielsweise so ausgewählt, dass seine Wellenlänge maximaler Transmission der gewünschten Wellenlänge für die erzeugte Laserstrahlung 28a, 28b entspricht. In diesem Fall kann der Ansteuerstrom I1, I2 (Figur 3) für den Halbleiterlaser 31 während der erfindungsgemäßen Betriebsphasen B1, B2 mit dem Ziel der Maximierung des Ausgangssignals des Detektors 3120 gewählt werden. Ganz besonders vorteilhaft kann der Ansteuerstrom I1, I2 für die erfindungsgemäßen Betriebsphasen B1, B2 demnach direkt in Abhängigkeit des Ausgangssignals des Detektors 3120 eingestellt werden.

Beispielsweise ist es möglich, während der ersten Betriebsphase B1 den ersten Ansteuerstrom I1 analog zu dem in Figur 3 abgebildeten Ansteuervorgang zu wählen. Gleichzeitig wird das Ausgangssignal des Detektors 3120 - beispielsweise von der Steuereinrichtung 305 - analysiert. Das Ausgangssignal des Detektors 3120 weist zu Beginn der Ansteuerung einen verhältnismäßig geringen Wert auf, weil der Halbleiterlaser 31 noch nicht auf seine Solltemperatur Tsoll erwärmt worden ist und dementpsrechend noch nicht die gewünschte Wellenlänge emittiert, auf die die Filter- und Detektoranordnung 3110, 3120 abgestimmt ist.

Das Ende der ersten Betriebsphase B1 wird durch ein Maximum des Ausgangssignals des Detektors 3120 angezeigt, das sich dann ergibt, wenn der Halbleiterlaser 31 aufgrund seiner betriebsbedingten Erwärmung nunmehr die gewünschte Wellenlänge emittiert, auf die die Filter- und Detektoranordnung 3110, 3120 abgestimmt ist.

Anschließend wird für die zweite Betriebsphase B2 der zweite Ansteuerstrom I2 so eingestellt, dass das Ausgangssignal des Detektors 3120 im Bereich seines zuvor detektierten Maximums verbleibt. Dies entspricht dem Konstanthalten der gewünschten Ausgangswellenlänge bzw. einer entsprechenden Temperierung des Halbleiterlasers 31. Wie bereits bei der gesteuert betriebenen Erfindungsvariante beschrieben wird die zweite Betriebsphase B2 auch im geregelten Fall zunächst eine Absenkung des zweiten Ansteuerstroms I2 zum Gegenstand haben, um einer unerwünschten weiteren Erwärmung des Halbleiterlasers 31 über die Solltemperatur Tsoll hinaus entgegenzuwirken.

Im Gegensatz zu der gesteuerten Variante kann bei dem geregelten Betrieb jedoch auch flexibel auf Fehlfunktionen reagiert werden. Beispielsweise kann bei einer plötzlich auftretenden Fehlfunktion eines den Halbleiterlaser 31 kühlenden Kühlsystems das zu schnelle Ansteigen der Temperatur T erkannt werden, und es können geeignete Gegenmaßnahmen eingeleitet werden, die eine Überschreitung der maximal zulässigen Junctiontemperatur und damit die Zerstörung des Halbleiterlasers 31 verhindern. In einem derartigen Fehlerfall kann bei dem geregelten Betrieb der Ansteuerstrom I1, I2 beispielsweise vorteilhaft so klein gewählt werden, dass die maximal zulässige Junctiontemperatur keinesfalls überschritten wird.

Ferner sind bei dem geregelten Betrieb vorteilhaft Exemplarstreuungen in der Stromansteuerung, beispielsweise bei entsprechenden Treiberschaltungen usw., sowie bei dem Design des Halbleiterlasers 31 kompensierbar, so dass unter Anwendung des erfindungsgemäßen Prinzips.stets Pumplicht 28a mit der gewünschten Wellenlänge bereitgestellt werden kann.

Eine weitere besonders vorteilhafte Ausführungsform des erfindungsgemäßen Halbleiterlasermoduls 3100' ist in Figur 5 abgebildet. Im Unterschied zu der vorstehend unter Bezugnahme auf die Figuren 4A, 4B beschriebenen Konfiguration weist das Halbleiterlasermodul 3100' nach Figur 5 zwei Filter- und Detektoranordnungen 3110, 3120; 3111, 3121 auf, die beide wiederum so in dem Halbleiterlasermodul 3100' angeordnet sind, dass sie dem Streulicht 28b ausgesetzt sind.

Die optischen Filter 3110, 3111 weisen Wellenlängen maximaler Transmission auf, die sich um wenige Nanometer, speziell weniger als 10 nm, besonders bevorzugt um weniger als 4 nm, voneinander unterscheiden. Die zugehörigen Detektoren 3120, 3121 können wie bereits der Detektor aus Figur 4A als Photodiode und - im Gegensatz zu den optischen Filtern 3110, 3111 - vorteilhaft auch gleichartig ausgebildet sein.

Diese Erfindungsvariante ermöglicht unter Auswertung der Ausgangssignale beider Detektoren 3120, 3121 vorteilhaft eine Erkennung der Änderungsrichtung der Wellenlänge des Streulichts und damit auch der Temperatur T des Halbleiterlasers 31 während des Erwärmens bzw. Abkühlens, wodurch eine noch präzisere Einregelung der Solltemperatur Tsoll ermöglicht wird.

Das erfindungsgemäße Verfahren ermöglicht die Erzeugung von Laserstrahlung mit konstanter Wellenlänge und ermöglicht somit eine effiziente Nutzung der Halbleiterlaserenergie, insbesondere zum optischen Pumpen eines Festkörperlasers. Darüberhinaus ergibt sich durch das erfindungsgemäße Prinzip eine Kostenersparnis sowohl bei der Herstellung des Halbleiterlasers 31 als auch bei dem Aufwand zur Einleitung der erzeugten Laserstrahlung 28a in eine Lichtleitfaser 28.

Bei dem optischen Pumpen einer Lasereinrichtung 26 mittels der erfindungsgemäß erzeugten Laserstrahlung 28a ist aufgrund der konstanten Wellenlänge der weitere Vorteil gegeben, dass die Absorptionslänge der Laserstrahlung 28a in der gepumpten Lasereinrichtung 26 konstant und verhältnismäßig gering ist, so dass die Lasereinrichtung 26 mit dem kleinstmöglichen Bauvolumen realisiert werden kann, was wiederum auf eine Kostenersparnis führt.

Gleichzeitig ist durch das erfindungsgemäße Betriebsverfahren vorteilhaft sichergestellt, dass die zulässige Maximaltemperatur in dem Halbleiterlaser 31 nie überschritten wird.

Bei gestapelten Halbleiterlaseranordnungen (nicht gezeigt), die eine Hintereinanderschaltung mehrerer Halbleiterlaser innerhalb derselben Epitaxieschicht aufweisen, ist das erfindungsgemäße Verfahren so auszulegen, dass die Temperatur des innersten Halbleiterlasers betrachtet wird. Die weiter außen in der Epitaxieschicht liegenden Halbleiterlaser sind so auszulegen, dass sie bei ihrer aufgrund der besseren Kühlung entsprechend geringeren Betriebstemperatur möglichst dieselbe Wellenlänge emittieren wie der innerste Halbleiterlaser, dessen Temperatur und damit Wellenlänge nach dem erfindungsgemäßen Prinzip geregelt wird.

Die optischen Filter 3110, 3111 können vorteilhaft beispielsweise als Interferenzfilter oder auch als Kantenfilter ausgebildet sein.

## Patentansprüche

1. Verfahren zum Betreiben eines Halbleiterlasers (31), bei dem der Halbleiterlaser (31) in einer ersten Betriebsphase (B1) so mit einem ersten Ansteuerstrom (11) angesteuert wird, dass er ausgehend von einer Ausgangstemperatur (T0) eine vorgebbare Solltemperatur (Tsoll) annimmt, wobei der Halbleiterlaser (31) auf eine Solltemperatur (Tsoll), die größer ist als die Ausgangstemperatur (T0), erwärmt wird, wobei der Halbleiterlaser (31) in einer zweiten Betriebsphase (B2), die auf die erste Betriebsphase (B1) folgt, so mit einem zweiten Ansteuerstrom (I2), der einen nichtkonstanten Zeitverlauf aufweist und sich kontinuierlich verringert, angesteuert wird, dass der Halbleiterlaser (31) die Solltemperatur (Tsoll) während der zweiten Betriebsphase (B2) beibehält, **dadurch gekennzeichnet, dass** der erste Ansteuerstrom (I1) einen konstanten Zeitverlauf aufweist und einem maximalen während der ersten Betriebsphase (B1) und der zweiten Betriebsphase (B2) auftretenden Ansteuerstrom (Imax) entspricht.

2. Verfahren nach Anspruch 1, **dadurch gekennzeichnet, dass** der zweite Ansteuerstrom (I2) sich kontinuierlich bis auf einen zum Aufrechterhalten der Solltemperatur (Tsoll) erforderlichen Minimalwert (Imin) verringert.

3. Verfahren nach einem der vorstehenden Ansprüche, **dadurch gekennzeichnet, dass** die Solltemperatur (Tsoll) einer maximalen Junctiontemperatur des Halbleiterlasers (31) während der ersten Betriebsphase (B1) und der zweiten Betriebsphase (B2) entspricht.

4. Verfahren nach einem der vorstehenden Ansprüche, **dadurch gekennzeichnet, dass** eine von einer Wellenlänge der von dem Halbleiterlaser (31) erzeugten Laserstrahlung abhängige Größe messtechnisch ermittelt wird.

5. Verfahren nach Anspruch 4, **dadurch gekennzeichnet, dass** von dem Halbleiterlaser (31) erzeugte Strahlung, insbesondere Streulicht (28b), mittels eines optischen Filters (3110) gefiltert wird, und dass die gefilterte Strahlung mittels eines Photodetektors (3120) detektiert wird.

6. Verfahren nach Anspruch 5, **dadurch gekennzeichnet, dass** in Abhängigkeit eines Ausgangssignals des Photodetektors (3120) der Ansteuerstrom (I1, I2) eingestellt wird.

7. Verfahren nach einem der vorstehenden Ansprüche, **dadurch gekennzeichnet, dass** der Halbleiterlaser (31) zum optischen Pumpen einer Lasereinrichtung (26) verwendet wird, wobei die Gesamtdauer des Verfahrens, bestehend aus einer ersten und einer zweiten Betriebsphase (B1, B2), zwischen 50 µs und 5 ms, bevorzugt zwischen 200 µs und 1 ms, beträgt.

8. Vorrichtung, umfassend einen Halbleiterlaser (31) und eine Steuereinrichtung (305) zur Ansteuerung des Halbleiterlasers (31) mit einem Ansteuerstrom (I1, I2), **dadurch gekennzeichnet, dass** die Vorrichtung zur Ausführung des Verfahrens nach einem der vorstehenden Ansprüche 1 bis 3 ausgebildet ist.

## Claims

1. Method for operating a semiconductor laser (31), wherein the semiconductor laser (31) is driven in a first operating phase (B1) with a first drive current (I1) such that it assumes a predefinable desired temperature (T_{desired}) starting from an initial temperature (TO), wherein the semiconductor laser (31) is heated to a desired temperature (T_{desired}) that is greater than the initial temperature (TO), wherein the semiconductor laser (31) is driven in a second operating phase (B2), which follows the first operating phase (B1), with a second drive current (12), which has a non-constant time profile and continuously decreases, such that the semiconductor laser (31) maintains the desired temperature (T_{desired}) during the second operating phase (B2), **characterized in that** the first drive current (I1) has a constant time profile and corresponds to a maximum drive current (Imax) occurring during the first operating phase (B1) and the second operating phase (B2).

2. Method according to Claim 1, **characterized in that** the second drive current (12) decreases continuously to a minimum value (Imin) required for maintaining the desired temperature (T_{desired}) .

3. Method according to either of the preceding claims, **characterized in that** the desired temperature (T_{desired}) corresponds to a maximum junction temperature of the semiconductor laser (31) during the first operating phase (B1) and the second operating phase (B2).

4. Method according to any of the preceding claims, **characterized in that** a variable dependent on a wavelength of the laser radiation generated by the semiconductor laser (31) is determined metrologically.

5. Method according to Claim 4, **characterized in that** radiation generated by the semiconductor laser (31), in particular scattered light (28b), is filtered by means of an optical filter (3110), and **in that** the filtered radiation is detected by means of a photodetector (3120).

6. Method according to Claim 5, **characterised in that** the drive current (I1, 12) is set depending on an input signal of the photodetector (3120).

7. Method according to any of the preceding claims, **characterized in that** the semiconductor laser (31) is used for optically pumping a laser device (26), wherein the total duration of the method, consisting of a first and of a second operating phase (B1, B2), is between 50 µs and 5 ms, preferably between 200 µs and 1 ms.

8. Apparatus comprising a semiconductor laser (31) and a control device (305) for driving the semiconductor laser (31) with a drive current (I1, 12), **characterized in that** the apparatus is designed for performing the method according to any of the preceding Claims 1 to 3.

## Revendications

1. Procédé de mise en fonctionnement d'un laser à semi-conducteur (31), dans lequel le laser à semi-conducteur (31) est attaqué lors d'une première phase de fonctionnement (B1) avec un premier courant d'attaque (I1) de manière à ce qu'il passe d'une température initiale (T0) à une température de consigne (Tconsigne) pouvant être prédéterminée, dans lequel le laser à semi-conducteur (31) est chauffé à une température de consigne (Tconsigne) qui est supérieure à la température initiale (TO), dans lequel le laser à semi-conducteur (31) est attaqué lors d'une seconde phase de fonctionnement (B2) qui suit la première phase de fonctionnement (B1), avec un second courant d'attaque (12) présentant une évolution temporelle non constante et diminuant continument, de telle manière que le laser à semi-conducteur (31) reste à la température de consigne (Tconsigne) au cours de la seconde phase de fonctionnement (B2), **caractérisé en ce que** le premier courant d'attaque (I1) présente une évolution temporelle constante et corresponde à un courant d'attaque maximal (Imax) se produisant au cours de la première phase de fonctionnement (B1) et de la seconde phase de fonctionnement (B2).

2. Procédé selon la revendication 1, **caractérisé en ce que** le second courant d'attaque (12) diminue continument jusqu'à une valeur minimale (Imin) nécessaire au maintien de la température de consigne (Tconsigne).

3. Procédé selon l'une quelconque des revendications précédentes, **caractérisé en ce que** la température de consigne (Tconsigne) correspond à une température de jonction maximale du laser à semi-conducteur (31) au cours de la première phase de fonctionnement (B1) et de la seconde phase de fonctionnement (B2).

4. Procédé selon l'une quelconque des revendications précédentes, **caractérisé en ce qu'**une grandeur est obtenue par une technique de mesure en fonction d'une longueur d'onde du rayonnement laser généré par le laser à semi-conducteur (31).

5. Procédé selon la revendication 4, **caractérisé en ce que** le rayonnement généré par le laser à semi-conducteur (31), notamment la lumière diffusée (28b), est filtré au moyen d'un filtre optique (3110)' et **en ce que** le rayonnement filtré est détecté au moyen d'un photodétecteur (3120).

6. Procédé selon la revendication 5, **caractérisé en ce que** le courant d'attaque (I1, I2) est réglé en fonction d'un signal de sortie du photodétecteur (3120).

7. Procédé selon une quelconque des revendications précédentes, **caractérisé en ce que** le laser à semi-conducteur (31) est utilisé à des fins de pompage optique d'un dispositif à laser (26), dans lequel la durée totale du procédé, constituée d'une première et d'une seconde phase de fonctionnement (B1, B2), est comprise entre 50 µs et 5 ms et de préférence, entre 200 µs et 1 ms.

8. Dispositif comprenant un laser à semi-conducteur (31) et un dispositif de commande (305) destiné à attaquer le lasser à semi-conducteur (31) avec un courant d'attaque (I1, I2), **caractérisé en ce que** le dispositif est conçu pour mettre en oeuvre le procédé selon l'une quelconque des revendications 1 à 3.
